## Europäisches Patentamt

## European Patent Office

## Office européen des brevets

(11) Veröffentlichungsnummer: **0 088 435**
A2

(12) **EUROPÄISCHE PATENTANMELDUNG**

(21) Anmeldenummer: **83102273.6**

(22) Anmeldetag: **08.03.83**

(51) Int. Cl.³: **H 01 L 41/04, B 41 J 3/04**

(30) Priorität: **10.03.82 DE 3208679**

(43) Veröffentlichungstag der Anmeldung: **14.09.83**
**Patentblatt 83/37**

(84) Benannte Vertragsstaaten: **FR GB IT NL SE**

(71) Anmelder: **SIEMENS AKTIENGESELLSCHAFT, Berlin und München Wittelsbacherplatz 2,**
**D-8000 München 2 (DE)**

(72) Erfinder: **Bork, Klaus, Appenzeller Strasse 125,**
**D-8000 München 71 (DE)**
Erfinder: **Humbs, Rolf, Dipl.-Ing., Melchiorstrasse 2,**
**D-8000 München 71 (DE)**
Erfinder: **Trey, Karl, Bruderhofstrasse 32,**
**D-8000 München 70 (DE)**

(54) **Vorrichtung zum Kontaktieren von in Kunststoff zu vergiessenden röhrenförmigen Piezowandlern.**

(57) Die Kontaktierungsvorrichtung für die röhrenförmigen Piezowandler in Schreibköpfen von Tintenschreibeinrichtungen besteht aus einem ersten Kontaktierungselement aus einer inneren Kontakthülse, die sich elastisch an die innere Wandung des Wandlerelementes anlegt und einem sich an den Kontaktbereich anschließenden flexiblen Abstandshalter, einem zweiten Kontaktierungselement aus einem federnden Anschlußstück mit einer das Wandlerelement von außen elastisch umfassenden Klammer und Durchführungslöcher für die Tintenkanäle der Wandlerelemente und Aufnahmeöffnungen für die Kontaktierungslemente aufweisenden Leiterplatte. Die Kontaktierungslemente sind dabei so ausgestaltet, daß nach dem Einstecken der Kontaktierungselemente in die Leiterplatte die Wandlerelemente sich über den Durchführungslöchern der Leiterplatte befinden.

SIEMENS AKTIENGESELLSCHAFT
Berlin und München

Unser Zeichen:
VPA 82 P 1169 E

0088435

Vorrichtung zum Kontaktieren von in Kunststoff
zu vergießenden röhrenförmigen Piezowandlern.
-------------------------------------------------

Die Erfindung betrifft eine Vorrichtung zum Kontaktieren
von in Kunststoff zu vergießenden, in Reihen angeordneten,
röhrenförmigen piezoelektrischen Wandlerelementen in
Schreibköpfen von Tintenschreibeinrichtungen.

Aus der DE-OS 27 40 773 ist eine Vorrichtung zum Kontaktieren von in Kunststoff zu vergießenden, in Reihen
angeordneten, röhrenförmigen und von der Tintenaustrittsöffnung strahlenförmig wegfluchtenden piezoelektrischen
Wandlerelementen in Schreibköpfen von Tintenschreibeinrichtungen bekannt, die aus einer blattförmigen flexiblen
Leiterfolie besteht, auf die über Drahtwendel von innen
kontaktierte Wandlerelemente ausgelöst werden. Danach
wird die gesamte Anordnung dann in Kunststoff vergossen,
wobei durch die Wandlerelemente gesteckte und nach dem
Aushärten des Kunststoffes wieder entfernte Drahtstücke
zur Lagefixierung und zur Bildung der Tintenkanäle dienen.

Eine derartige Herstellungsweise ist bei Großserien
relativ kostenaufwendig, zumal eine Automatisierung
des Herstellungsprozesses nur bedingt möglich ist.

Aufgabe der Erfindung ist es, eine Vorrichtung zum
Kontaktieren von in Kunststoff zu vergießenden, in Reihen

MM 1 Wt / 9.3.1982

0088435

angeordneten röhrenförmigen piezoelektrischen Wandlerelementen im Schreibkopf von Tintenschreibeinrichtungen
bereitzustellen, die eine weitgehende Automatisierung
des Kontaktierungsvorganges ermöglicht und die Herstellung des Schreibkopfes vereinfacht.

Diese Aufgabe wird bei einer Vorrichtung der eingangs genannten Art durch ein erstes Kontaktierungselement aus
einer inneren Kontakthülse mit einem sich elastisch an
die innere Wandung des Wandlerelementes anliegenden
Kontaktbereich und einem sich an diesem Kontaktbereich
anschließenden flexiblen Abstandhalter und einem zweiten
Kontaktelement aus einer mit einem federnden Anschluß verbundenen, das Wandlerelement von außen elastisch umfassenden Klemmer und Durchführungslöcher für die Tintenkanäle der Wandlerelemente und Aufnahmeöffnungen für
die Kontaktierungselemente aufweisenden Leiterplatte
gelöst, wobei die Durchführungslöcher und die Aufnahmeöffnungen so auf der Leiterplatte angeordnet sind, daß
sich nach Befestigung der Kontaktierungselemente auf der
Leiterplatte die Wandlerelemente im Abstand über den
Ausrichtöffnungen befinden.

Die Erfindung ermöglicht es, die aus piezoelektrischen
Röhrchen bestehenden Wandlerelemente automatisch mit
gestanzten Kontaktierungselementen zu bestücken und
rechtwinklig in einer Ebene mit Aufnahmeöffnungen für
die Kontaktierungselemente versehene Leiterplatten einzusetzen.

Nach dem Einsetzen der Wandlerelemente in die Aufnahmeöffnungen der Leiterplatte erfolgt eine gemeinsame
Schwall- oder Schlepplötung. Sämtliche Kontaktierungselemente sind im Fußbereich elastisch ausgebildet, so
daß eine für die Schreibkopfmontage im Gießprozess

BAD ORIGINAL

erforderliche Schräglage der Wandlerelemente möglich
ist. Die beim Gießprozess zur Erzeugung der Tintenkanäle erforderlichen und nach dem Vergießen wieder
entfernten Drahtstücke können durch die Leiterplatte
in die Wandlerelemente eingefädelt werden, wobei die
in der Leiterplatte vorgesehenen Ausrichtöffnungen das
Einfädeln der Drahtenden erleichtern.

Weitere vorteilhafte Ausführungsformen der Erfindung sind
in den Unteransprüchen gekennzeichnet.

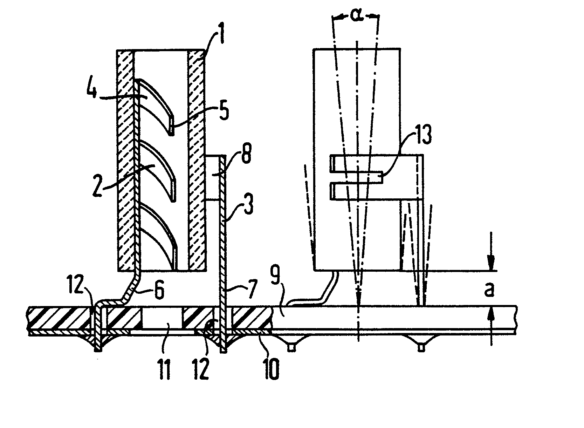

Eine Ausführungsform der Erfindung ist in der Zeichnung
dargestellt und wird im folgenden beispielsweise näher
beschrieben.

Die Figur zeigt eine schematische Darstellung von zwei
auf einer Leiterplatte kontaktierten piezoelektrischen
Wandlerelementen.

Die in der Zeichnung dargestellte Vorrichtung zum
Kontaktieren von Kunststoff zu vergießenden. in Reihen
angeordneten, röhrchenförmigen Piezowandlerelementen 1
für Schreibköpfe in Tintenschreibeinrichtungen besteht
im wesentlichen aus zwei Kontaktierungselementen, nämlich einem ersten Kontaktierungselement 2 und einem
zweiten Kontaktierungselement 3. Beide Kontaktierungselemente 2 und 3 sind im Stanzverfahren einstückig aus
Metall hergestellt. Das erste Kontaktierungselement 2
besteht dabei aus einer inneren Kontaktierungshülse 4
mit einem sich radialelastisch an die innere Wandung
des Wandlerelementes 1 anlegenden Kontaktbereich 5 und
einem sich an diesem Kontaktbereich anschließenden
flexiblen Abstandhalter 6. Das zweite Kontaktierungselement 3 besteht aus einem federnden Anschlußstück 7
und einer das Wandlerelement von außen elastisch umfassenden Klammer 8.

BAD ORIGINAL

0088435

Die Wandlerelemente 1 werden über eine hier nicht dargestellte automatische Vorrichtung mit den gestanzten Kontaktierungselementen bestückt, wobei die Kontaktierungselemente so ausgebildet sind, daß sie einerseits über die innere Kontakthülse und andererseits über die Klammer 8 mit dem Wandlerelement 1 verbunden sind.

Zur Befestigung der Wandlerelemente ist eine Leiterplatte 9 vorgesehen, die einseitig Leiterbahnen 10 zur Ansteuerung der Wandlerelemente aufweist. Die Leiterplatte 9 weist einerseits Durchführungslöcher 11 für die Tintenkanäle der Wandlerelemente 1 und Aufnahmeöffnungen 12 für den elastischen Fußbereich der Kontaktierungselemente auf. Die Aufnahmeöffnungen 12 sind beidseitig der Durchführungslöcher 11 angeordnet, wobei die Kontaktierungselemente in ihrem Fußbereich so ausgebildet sind, daß nach dem Einstecken der Kontaktierungselemente in die Aufnahmeöffnungen 12 die zentrale Öffnung der Wandlerelemente 1 direkt über den Durchführungslöchern 11 im Abstand a zu liegen kommt.

Nach dem Einstecken der Kontaktierungselemente in die zugehörigen Aufnahmeöffnungen 12 der Leiterplatte 9 erfolgt eine Schwall- oder Schlepplötung zur elektrischen Kontaktierung der Kontaktierungselemente mit den Leiterbahnen 10 der Leiterplatte 9.

Die elastische Ausgestaltung des als Abstandhalter dienenden Fußes des ersten Kontaktierungselementes 2 in Verbindung mit dem federnden Anschlußstück 7 des zweiten Kontaktierungselementes ermöglicht ein Verschwenken des Wandlerelementes 1, um den Winkel $\alpha$ bei der anschließenden Montage des Schreibkopfes. Zu diesem Zwecke werden durch die Durchführungsöffnungen 11 Drahtstücke gesteckt und über diese Drahtstücke erfolgt

BAD ORIGINAL

0088435

dann beim Vergießen eine Ausrichtung der Wandlerelemente entsprechend der gewünschten Zielrichtung der Tintenkanäle.

Für die Ausgestaltung der Kontaktierungselemente sind noch andere Ausführungsformen denkbar. So ist es möglich, die innere Kontakthülse des Kontaktierungselementes 2 so auszugestalten, daß sie aus einer kammartig aufgefächerten Halbspirale besteht, die besonders einfach ausgestanzt werden kann. Zusätzliche Schlitzöffnungen 13 an der von außen das Wandlerelement umfassenden Klammer 8 erhöhen deren Elastizität. Die sich daraus bildenden Einzelfinger verbessern die Kontaktfähigkeit.

Bei der Ausgestaltung der Kontaktierungselemente hinsichtlich ihrer elastischen Eigenschaften ist zu beachten, daß die die Kontakte an den Wandlerelementen erzeugenden Elemente hinsichtlich ihrer Kontaktkraft so ausgebildet sind, daß beim Vergießen kein Unter-kriechen der Kontaktierungselemente erfolgt.

BAD ORIGINAL

Patentansprüche

1. Vorrichtung zum Kontaktieren von in Kunststoff zu vergießenden, in Reihen angeordneten, röhrenförmigen piezoelektrischen Wandlerelementen in Schreibköpfen von Tintenschreibeinrichtungen,
g e k e n n z e i c h n e t durch ein erstes Kontaktierungselement (2) aus einer inneren Kontakthülse (4) und einem sich elastisch an die innere Wandung des Wandlerelements (1) anliegenden Kontaktbereich (5) und einem sich an diesem Kontaktbereich anschließenden flexiblen Abstandhalter (6), ein zweites Kontaktierungselement (3) aus einer mit einem federnden Anschlußstück (7) verbundenen, das Wandlerelement von außen elastisch umfassenden Klammer (8) und Durchführungslöcher für die Tintenkanäle der Wandlerelemente (1) und Aufnahmeöffnungen (12) für die Kontaktierungselemente aufweisende Leiterplatte (9), wobei die Durchführungslöcher (11) und die Aufnahmeöffnungen (12) so auf der Leiterplatte (9) angeordnet sind, daß sich nach Befestigung der Kontaktierungselemente (2,3) auf der Leiterplatte die Wandlerelemente (1) im Abstand über den Ausrichtöffnungen (11) befinden.

2. Vorrichtung nach Anspruch 1, dadurch gekennzeichnet, daß die Kontaktierungselemente (2,3) aus einem einstückig hergestellten Stanzteil bestehen.

BAD ORIGINAL

0088435

3. Vorrichtung nach einem der Ansprüche 1 oder 2, dadurch gekennzeichnet, daß die innere Kontakthülse (4) aus einer kammartig aufgefächerten Halbspirale besteht.

BAD ORIGINAL

0088435